# EUROPEAN PATENT APPLICATION

(11) **EP 3 128 676 A1**
(43) Date of publication of application: **08.02.2017**
(21) Application number: 16182147.5
(22) Date of filing: 01.08.2016
(51) Int. Cl.: H04B 1/26, H04N 5/44

(54) **RECEIVING DEVICE**

(30) Priority: 06.08.2015 JP 2015156462
(71) Applicant: Funai Electric Co., Ltd., Daito Osaka 574-0013 (JP)
(72) Inventor: Nakagawa, Yoshio, Osaka, 574-0013 (JP)
(74) Representative: Becker Kurig Straus

(57) **Abstract**

A receiving device (10) is provided, and has a tuner circuit (15), a frequency characteristic detector (18) and an adjusting part (13, 14). The tuner circuit (15) is capable of receiving a broadcasting signal. The frequency characteristic detector (18) detects a tilt in a predetermined frequency band, wherein the tilt is presented by connecting waveform peaks that show a frequency characteristic of a receiving signal. The adjusting part (13, 14) changes the tilt by adjusting a signal level of the predetermined frequency band.

## Description

### BACKGROUND OF THE INVENTION

### Field of the Invention

The invention relates to a receiving device capable of reception over a predetermined frequency band, to which multiple channels are allocated.

### Description of Related Art

In the case of receiving a satellite broadcasting signal, depending on the environments, the signal intensity on the BS (broadcasting satellite) side is high while the signal intensity on the CS (communications satellite) side is low, and therefore there may be a frequency characteristic that the height difference becomes a steep tilt waveform. The reason is that transmission loss tends to increase on the side of high frequency. When such a frequency characteristic is present, programs of the high frequency side on the CS side cannot be viewed sometimes. In order to alleviate this problem, it is necessary to incorporate a system for correction.

Traditionally, a tilt correction (adjustment) circuit has been used for eliminating the tilt of the waveform of the frequency characteristic. Patent Literature 1 (Japanese Patent Publication No. 2007-201584) has disclosed that "the equalizers 8 and 38 are components for changing the tilt of the tilt characteristic, which is given to the corresponding community reception signal in accordance with the value of the supplied control voltage, within a predetermined adjustable range."

Also, as disclosed in Patent Literature 1, a tilt correction circuit for changing the tilt of the tilt characteristic within the predetermined adjustable range, which may be built in such a booster or the like, is adjusted manually by turning a knob. Moreover, if the same correction is forcibly incorporated into an environment that does not require tilt correction, sometimes there are only disadvantages, such as drop of reception sensitivity. Thus, it is not necessary to forcibly apply correction to an environment where tilt correction is not required.

### SUMMARY OF THE INVENTION

According to the disclosure, tilt of the tilt characteristic is improved easily within the required range.

According to one embodiment, the disclosure provides a receiving device, including a tuner circuit capable of receiving broadcasting signals; a frequency characteristic detector detecting a tilt in a predetermined frequency band, wherein the tilt is presented by connecting waveform peaks that show a frequency characteristic of a receiving signal; and an adjusting part changing the tilt by adjusting a signal level of the predetermined frequency band.

In another embodiment of the disclosure, the receiving device may include a reception condition detector which detects a reception condition in a plurality of channels of the predetermined frequency band, and the frequency characteristic detector detects the tilt of the waveform of the frequency characteristic based on the reception condition.

In the aforementioned configuration, the tuner circuit is capable of reception over the predetermined frequency band, to which multiple channels are allocated. When the reception condition detector detects the reception condition pertaining to quality of reception in the channels over a part or all of the frequency band, the frequency characteristic detector detects the tilt of the waveform of the frequency characteristic based on the detected reception condition. Then, the adjusting part makes a tilt correction to adjust and reduce a degree of the tilt.

The range of frequency in a broad band being wide is a situation where the tilt of the frequency characteristic may cause a problem. In another embodiment of the invention which is suitable for such a situation, the predetermined frequency band may have a range which covers a first frequency band and a second frequency band having a higher frequency than the first frequency band.

In the aforementioned configuration, if the predetermined frequency band includes the range which covers the first frequency band and the second frequency band having a higher frequency than the first frequency band, in a situation where the tuner receives signals from the first frequency band to the second frequency band, attenuation on the high frequency side of a transmission path from the antenna tends to increase. Thus, the high frequency side of the frequency characteristic falls and the tilt tends to increase. Even in such a case, it is possible to detect the tilt of the waveform of the frequency characteristic based on the detected reception condition and reflect the tilt correction so as to reduce the tilt. In Japan, the BS broadcasting band is an example of the first frequency band and the CS broadcasting band is an example of the second frequency band. In addition, the receivable frequency band may also include a terrestrial digital broadcasting band.

In another embodiment of the invention, the frequency characteristic detector detects a reception condition in a channel of the first frequency band and a reception condition in a channel of the second frequency band, and the adjusting part makes an adjustment to the tilt if the tilt exceeds a predetermined threshold value.

Conventionally, accurate detection of the tilt of the waveform of the frequency characteristic involves complicated calculation. However, generally when tilt occurs, the range of the quality of reception condition increases; and when there is less tilt, the range of the quality of reception condition is narrowed.

Therefore, the frequency characteristic detector detects the tilt of the waveform of the frequency characteristic based on the reception condition in the channel of the first frequency band and the reception state in the channel of the second frequency band, and the adjusting part makes an adjustment to the tilt if the tilt exceeds the predetermined threshold value, so as to achieve tilt correction in a simple way.

The reception condition may be determined by referring to various indexes. As an example, in another embodiment of the invention, the reception condition detector may detect a C/N value of each channel. As another example, in another embodiment of the invention, the reception condition detector may detect a BER value of each channel.

In the aforementioned configuration, the frequency characteristic detector may detect the tilt of the waveform of the frequency characteristic based on a difference between a maximum of the C/N values in the first frequency band and a minimum of the C/N values in the second frequency band, or based on a difference between a minimum of the C/N values in the first frequency band and a maximum of the C/N values in the second frequency band.

In the aforementioned configuration, the adjusting part may lower a level of the first frequency band and raise a level of the second frequency band if the C/N values of the first frequency band are large.

In the aforementioned configuration, the adjusting part may lower the level of the second frequency band and raise the level of the first frequency band if the C/N values of the second frequency band are large.

In another embodiment of the invention, the frequency characteristic detector may detect the tilt of the waveform of the frequency characteristic based on a difference between a maximum of the BER values in the first frequency band and a minimum of the BER values in the second frequency band, or based on a difference between a minimum of the BER values in the first frequency band and a maximum of the BER values in the second frequency band.

In another embodiment of the invention, the adjusting part may lower the level of the first frequency band and raise the level of the second frequency band if the BER values of the first frequency band are small.

In another embodiment of the disclosure, the adjusting part may lower the level of the second frequency band and raise the level of the first frequency band if the BER values of the second frequency band are small.

In another embodiment of the disclosure, after the adjusting part adjusts the tilt, if the tilt of the waveform of the frequency characteristic detected by the frequency characteristic detector based on the reception condition is larger than the tilt before the adjustment, the adjusting part may undo the adjustment made to the tilt.

In the aforementioned configuration, detection of the reception condition and detection of the tilt are performed after the tilt correction is performed. Then, the tilt correction is undone when the tilt increases and deteriorates. In this way, effects of the disclosure are achieved with a very simple configuration.

In another embodiment of the disclosure, when a setting of not viewing the second frequency band is detected and the second frequency band is not viewed, the adjusting part does not adjust the tilt.

When the tilt correction is performed, as an example, if the second frequency band is set as the CS broadcasting band and the first frequency band is set as the BS broadcasting band, the BS broadcasting band on the low frequency side tends to fall while the CS broadcasting band on the high frequency side tends to rise. If the CS broadcasting band is not received, it is not necessary to raise the CS broadcasting band until the favorable BS broadcasting band is lowered. Therefore, by detecting whether the setting of not viewing the CS broadcasting band is detected and the CS broadcasting band is not viewed, the adjusting part does not perform the tilt correction. Thus, it is possible to prevent deterioration of the reception condition in the BS broadcasting band.

There are many cases that the receiving device includes an antenna output terminal for self-reception and includes an antenna output terminal for an external device. The following embodiments are connection forms beneficial for such cases.

In the first embodiment, the configuration may include the antenna output terminal for the external device, and an output of the adjusting part is supplied to the tuner circuit and not supplied to the antenna output terminal.

In the second embodiment, the configuration may include an antenna output terminal for the external device, and an output of the adjusting part is supplied to the tuner and the antenna output terminal.

In the third embodiment, the configuration may include an antenna output terminal for the external device, and the adjusting part is provided individually for the tuner and the antenna output terminal.

In the fourth embodiment, the configuration may include an antenna output terminal for the external device, and an output of the adjusting part is not supplied to the tuner circuit but supplied to the antenna output terminal.

In the aforementioned configuration, the adjusting part includes an equalizer and an amplifier. The equalizer may make an adjustment to reduce the tilt. The amplifier may adjust a gain of the entire frequency band.

As described above, it can be easily understood that the means of detecting the tilt of the waveform of the frequency characteristic and reflecting the tilt correction to reduce the tilt is not necessarily limited to a substantial device and is also applicable as a method.

Therefore, in another embodiment of the invention, an adjustment method for the receiving device, which includes the tuner circuit that is capable of reception over the predetermined frequency band to which multiple channels are allocated, is provided. In the adjustment method, a process of detecting the reception condition pertaining to the quality of reception in multiple channels over a part or all of the frequency band, a process of detecting the tilt of the waveform of the frequency characteristic based on the detected reception condition, and a process of reflecting the tilt correction to reduce the tilt may be performed.

In other words, the disclosure is not necessarily limited to a substantial device and is also effective when implemented as a method.

According to the invention, the tilt of the waveform of the frequency characteristic is detected and tilt correction is reflected to reduce the tilt, and thus it is possible to automatically improve the tilt of the waveform of the frequency characteristic only when required.

### BRIEF DESCRIPTION OF THE DRAWINGS

FIG. 1 is a block diagram of the receiving device according to an embodiment of the invention.
FIG. 2 is a diagram showing the frequency characteristic of the receiving signal.
FIG. 3 is a flowchart of the process performed by the receiving device.
FIG. 4 is a diagram showing a tilt correction when the CS band is low.
FIG. 5 is a diagram showing a tilt correction when the BS band is low.
FIG. 6 is a diagram showing a screen for selecting a broadcasting wave to be viewed.
FIG. 7 is a block diagram of the receiving device according to another embodiment.
FIG. 8 is a block diagram of the receiving device according to another embodiment.
FIG. 9 is a block diagram of the receiving device according to another embodiment.

### DESCRIPTION OF THE EMBODIMENTS

### First Embodiment

Hereinafter, embodiments of the disclosure are described in detail with reference to the figures.

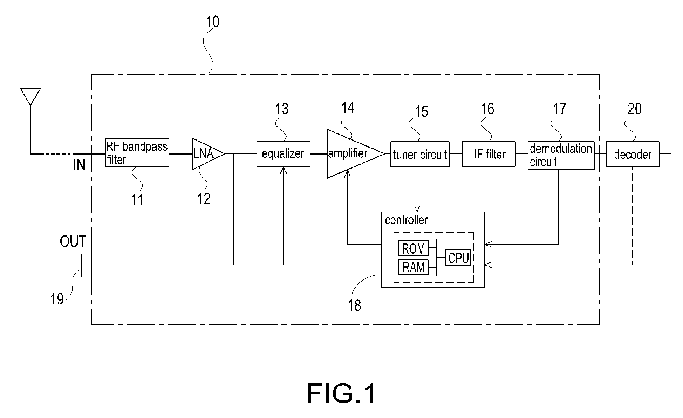

FIG. 1 illustrates a receiving device according to an embodiment of the invention by a block diagram. The receiving device is capable of receiving broadcasting signals of a BS broadcasting band and a CS broadcasting band.

Referring to the figure, a tuner 10 includes a RF bandpass filter (BPF) 11 that is connected with an antenna terminal and is set with a pass frequency band in a receiving frequency band, a low noise amplifier (LNA: high frequency amplifier) 12 that amplifies an output of the RF bandpass filter 11, an equalizer 13 used primarily for tilt correction, an amplifier 14 that amplifies an output of the equalizer 13 as required, a tuner circuit 15 that receives a broadcasting signal of a desired channel, an IF filter (LPF: low-pass filter) 16 that inputs an intermediate frequency signal outputted by the tuner circuit 15 to reduce an undesired signal component, a demodulation circuit 17 that demodulates based on the intermediate frequency signal, and a controller 18 that controls the foregoing. An antenna output terminal 19 is provided in the tuner 10 for outputting an antenna signal to an external receiver. In this embodiment, the so-called equalizer 13 or amplifier 14 may be regarded as a kind of filter in a broad sense.

The tuner circuit 15 adopts a super-heterodyne system, and the controller 18 controls a local oscillator in the tuner circuit 15 so as to oscillate at a local oscillating frequency corresponding to a receiving frequency. Moreover, the controller 18 controls the equalizer 13 and the amplifier 14 so as to improve a frequency characteristic of a receiving signal, which will be described later. In addition, the demodulation circuit 17 outputs a C/N value, which corresponds to a ratio of a signal component to a noise component during demodulation, to the controller 18.

A demodulation signal outputted from the demodulation circuit 17 is outputted to a decoder 20, and the decoder 20 converts the demodulation signal from an analog signal into a digital signal. At the moment, the decoder 20 calculates a bit error rate (BER), and the controller 18 may also use the BER. The tuner circuit 15, the demodulation circuit 17, and the controller 18 may be constituted by an integrated IC. Moreover, a CPU, a ROM, or a RAM capable of executing processing according to a program is incorporated into the controller 18.

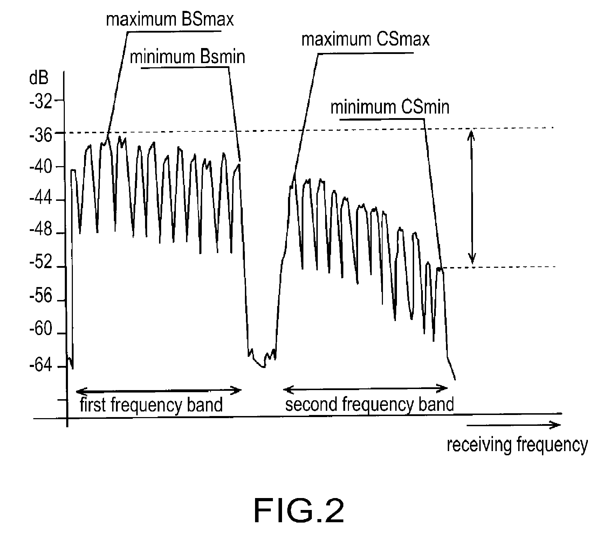

FIG. 2 is a diagram showing a frequency characteristic of intensity of the receiving signal. The horizontal axis indicates the frequency while the vertical axis indicates the intensity (level) of the receiving signal, and one graduation in the vertical axis is 4dB.

As shown in FIG. 2, a range from a first band on a low frequency side to a second band on a high frequency side is shown. Multiple channels are allocated over the frequency band. Referring to the figure, in each of the first band and the second band, a peak portion where the signal level rises and a valley portion where the signal level falls between the peak portions appear repeatedly at a constant frequency interval. The portion that forms the peak is a band where a channel number is allocated. Accordingly, the peak portion occurs repeatedly at the constant frequency interval. In addition, a no signal band, in which the signal level falls continuously, exists between the first band and the second band.

In this embodiment, a BS band (the first band) and a CS band (the second band) are illustrated as examples of the frequency bands that are used in Japan. Nevertheless, the disclosure is also applicable to a receiving device that receives signals with the first frequency band as the low frequency side and the second frequency band as the high frequency side. In addition to the above, the receiving device may include a terrestrial digital broadcasting wave in the frequency band. In the following embodiments, the first band and the second band are the BS band and the CS band respectively, for example.

A curve connecting peak values of the peak portions of the receiving signal is referred to as the frequency characteristic here, and it is known that the frequency characteristic of the receiving signal descends toward the right. Generally, the CS broadcasting band is on the high frequency side. Because transmission loss is larger on the high frequency side, the frequency characteristic tends to descend toward the right. Even though the frequency characteristic is found to tend to descend toward the right, it does not necessarily hinder reception of CS broadcast. Therefore, performing tilt correction by default may not be always good. As described above, since the curve that connects the peak values of the peak portions of the receiving signal is referred to as the frequency characteristic, the valley portions are not used particularly. In addition, only the peak values are to be processed. As shown in FIG. 2, in the BS band, a maximum of the peak values is a maximum BSmax and a minimum thereof is BSmin. Similarly, in the CS band, a maximum of the peak values is a maximum CSmax and a minimum thereof is CSmin.

Of course, not only the maximum or the minimum, other values that convey equivalent meanings may also be used for specifying the frequency characteristic. For example, an average of a predetermined frequency range centered on the maximum may be used. In this way, it is possible to avoid using a peak value resulting from noise as the maximum. The reason is that, if the peak value resulting from noise is used, the intensity of the receiving signal falls in the range before and after the peak value. In the case of the original maximum, however, the intensity of the receiving signal rises even in the range before and after the peak value.

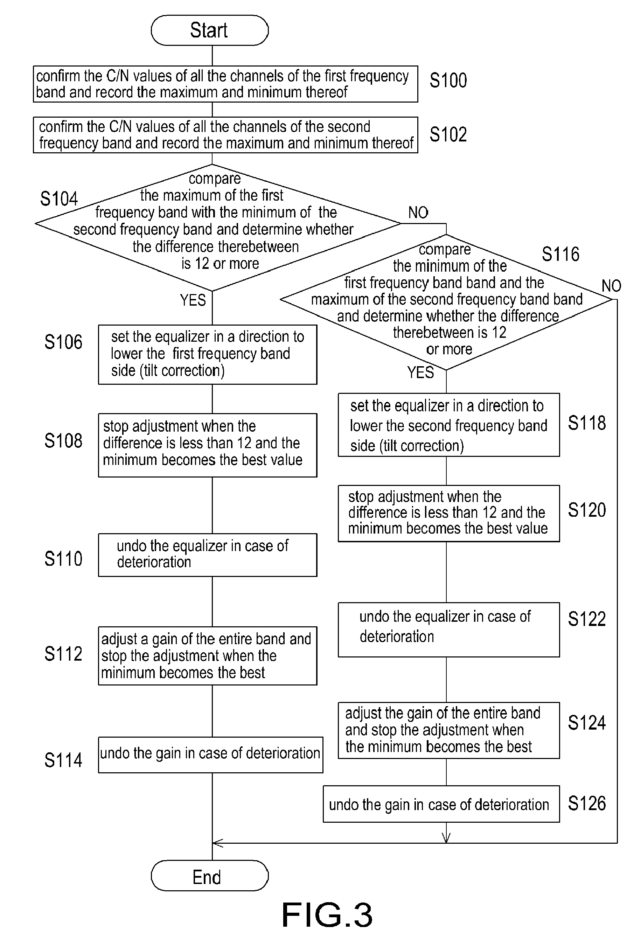

FIG. 3 is a flowchart of a process performed by the receiving device. In FIG. 3, the first band and the second band are exemplified by the BS band and the CS band respectively.

In Step S100, the CPU of the controller 18 confirms the C/N values of all the channels of the BS band and records the maximum and minimum thereof. The C/N values are detected by the demodulation circuit 17 and outputted to the controller 18. Because the signal intensity of noise does not vary significantly over the broadcasting band, it can be said that the C/N value is high when the signal intensity is high. Referring to FIG. 2, the maximum and the minimum of the signal intensity of the peak portion become the maximum BSmax and the minimum BSmin in the BS band. Next, in Step S102, the C/N values of all the channels of the CS band are confirmed and the maximum and minimum thereof are recorded. Similarly, referring to FIG. 2, the maximum and the minimum become the maximum CSmax and the minimum CSmin in the CS band.

Once the maximum BSmax and the minimum BSmin in the BS band and the maximum CSmax and the minimum CSmin in the CS band are obtained, in Step S104, the CPU compares the maximum of the BS band with the minimum of the CS band and determines whether a difference therebetween is 12 or more. In the case of the frequency characteristic shown in FIG. 2, the CS band has a great attenuation and the difference is 12 or more. Therefore, in Step S106, the CPU sets the equalizer 13 in a direction to lower the BS side. The adjustment made by the equalizer is a tilt correction.

Nevertheless, the C/N value is merely one example for detection of the frequency characteristic. Hence, other evaluation values may also be utilized to detect the frequency characteristic. In that case, the evaluation values may not be obtained from the demodulation circuit 17.

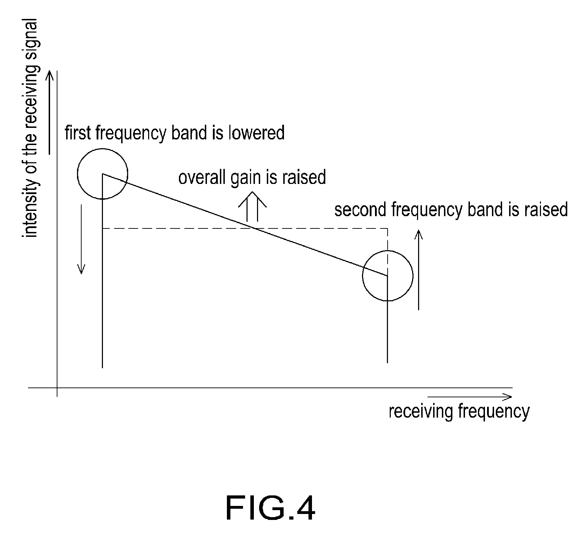

FIG. 4 is a diagram showing a tilt correction when the second band is low. The horizontal axis indicates the frequency while the vertical axis indicates the intensity of the receiving signal. FIG. 4 is a pattern diagram for illustrating the tilt correction and is presented in a simplified way. Moreover, in FIG. 4, the first band and the second band are the BS band and the CS band respectively. As shown in the figure, in the case of such tilt correction, if the signal intensity of the BS band is large, the BS band is lowered while the CS band is raised. Thereby, because the signal intensity of the BS band falls, the C/N value of the BS band decreases and the difference between the C/N value of the BS band and the C/N value of the CS band is reduced. It indicates that a tilt of a waveform of the frequency characteristic decreases.

The process of confirming the C/N values of all the channels of the BS band in Step S100 and the process of confirming the C/N values of all the channels of the CS band in Step S102 are equivalent to a reception condition detector that detects a reception condition pertaining to the quality of reception in multiple channels over a part or all of the frequency band, and the process of comparing the maximum of the BS band with the minimum of the CS band and determining whether the difference is 12 (here, 12 is only an example) or more in Step S104 is equivalent to a frequency characteristic detector that detects the tilt of the waveform of the frequency characteristic based on the detected reception condition, and further, based on the difference between the maximum in the band on the low frequency side and the minimum in the band on the high frequency side. Furthermore, in Step S106, the equalizer 13 is set in the direction to lower the BS side to eliminate the tilt, which is equivalent to an adjusting part that reflects the tilt correction to adjust and reduce the tilt. Alternatively, the frequency characteristic detector detects the tilt of the waveform of the frequency characteristic based on a reception condition in a channel of the first frequency band and a reception condition in a channel of the second frequency band, and the adjusting part makes an adjustment to reduce the tilt if the tilt exceeds a predetermined threshold value.

In this embodiment, the C/N value of each channel is detected to indicate the quality of the reception condition, and the demodulation circuit 17 or the controller 18 is equivalent to the reception condition detector.

As described above, the frequency band in this embodiment includes the range from the BS broadcasting band to the CS broadcasting band. Needless to say, the tilt correction of this embodiment is also applicable to a terrestrial digital broadcasting band. In that case, the frequency band includes the terrestrial digital broadcasting band.

As described above, upon determination of the tilt, the reception condition in the channels of the BS broadcasting band and the reception condition in the channels of the CS broadcasting band are detected, and at the moment, obtaining the difference between the maximum of the BS band and the minimum of the CS band is equivalent to obtaining the range of the quality of the reception condition. When the range exceeds a predetermined threshold value (the value 12 that serves as the difference, for example), it can be said that the tilt correction is performed to reduce the range of the quality of the reception condition. These are equivalent to the frequency characteristic detector and the adjusting part.

In Step S108, the CPU stops adjustment when the aforementioned difference is less than 12 and the minimum becomes the best value. That is, adjustment made to the equalizer 13 is stopped. Additionally, in Step S110, the CPU undoes the equalizer 13 if the tile deteriorates, i.e., the difference increases.

In Step S112, the CPU adjusts a gain of the entire band and stops the adjustment when the minimum becomes the best. That is, a gain of the amplifier 14 is set. FIG. 4 illustrates a case where the effect of the tilt correction and the overall gain are raised. After the tilt is reduced, the gain of the amplifier 14 is set to raise the overall level. Then, in Step S 114, whether the C/N value deteriorates is determined again, and the gain is undone if the C/N value deteriorates.

The processes of Steps S110 and S112 are equivalent to that after the tilt correction, the tilt is detected when detecting the reception condition, and then the tilt correction is undone if the tilt deteriorates. These are realized by the reception condition detector, the frequency characteristic detector, and the adjusting part.

In the example shown in FIG. 2, because the CS band has lower signal intensity than the BS band, in Step S104, the maximum of the BS band and the minimum of the CS band are compared to determine that the difference therebetween is 12 or more. Nevertheless, there may be cases where the frequency characteristic presents a reverse tilt.

When the result of determination in Step S104 is NO, the CPU compares the minimum of the BS band and the maximum of the CS band and determines whether the difference therebetween is 12 or more in Step S116. The result of determination is YES if it ascends toward the right extremely. Then, in Step S118, the CPU sets the equalizer 13 in a direction to lower the CS side.

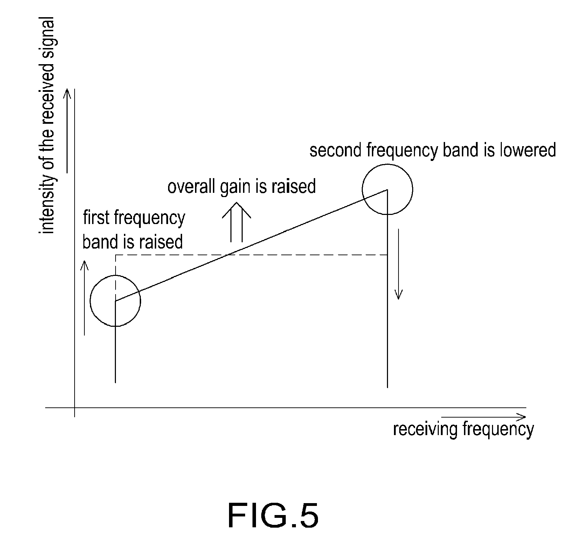

FIG. 5 is a diagram showing a tilt correction when the first band is low. The horizontal axis indicates the frequency while the vertical axis indicates the intensity of the receiving signal. FIG. 5 is a pattern diagram for illustrating the tilt correction and is presented in a simplified way. In FIG. 5, the first band and the second band are exemplified by the BS band and the CS band respectively.

As shown in the figure, in the case of such tilt correction, if the intensity of the CS band is large, the CS band is lowered while the BS band is raised. Thereby, because the signal intensity of the CS band falls, the C/N value of the CS band decreases and the difference between the C/N value of the CS band and the C/N value of the BS band is reduced. It indicates that the tilt of the waveform of the frequency characteristic decreases.

The process of comparing the maximum of the CS band with the minimum of the BS band and determining whether the difference is 12 or more in Step S116 is equivalent to the frequency characteristic detector that detects the tilt of the waveform of the frequency characteristic based on the detected reception condition, and further, by based on the difference between the maximum in the band on the low frequency side and the minimum in the band on the high frequency side. Furthermore, in Step S118, the equalizer 13 is set in the direction to lower the CS side to eliminate the tilt, which is equivalent to the adjusting part that reflects the tilt correction to reduce the tilt.

In Step S120, the CPU stops adjustment when the difference is less than 12 and the minimum becomes the best value. Additionally, in Step S122, the CPU undoes the equalizer when deterioration occurs.

Thereafter, like Step S 112, the CPU adjusts the gain of the entire band and stops the adjustment when the minimum becomes the best in Step S124. Further, in Step S126, whether the C/N value deteriorates is determined again, and the gain is undone if the C/N value deteriorates.

By performing the aforementioned processes, in the frequency band covering the BS band and the CS band, the tilt of the waveform of the frequency characteristic is detected with reference to the C/N values and the tilt is reduced by reflecting the tilt correction.

### Second Embodiment

In the aforementioned embodiment, the controller 18 obtains the C/N value from the demodulation circuit 17 for determining the quality of the reception condition. However, an index for determining the quality of the reception condition is not limited to the C/N value.

In another embodiment, the controller 18 may obtain the bit error rate (BER) from the decoder 20. An error is less likely to occur during decoding if the reception condition is good. Thus, the decoder 20 is able to determine the reception condition by referring to the BER.

In this way, the reception condition detector detects the BER value of each channel to determine the reception condition.

### Third Embodiment

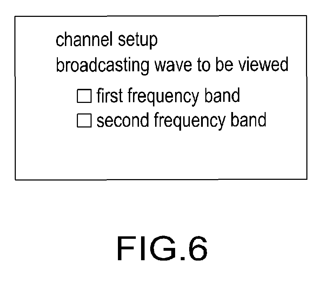

FIG. 6 is a diagram showing a screen for selecting a broadcasting wave to be viewed.

As shown in FIG. 2, even though the reception condition of the second band (the CS band) may be bad, it will not cause any problem if the user does not view the second band (the CS band) anyway. However, if the equalizer 13 carries out the tilt correction to lower the signal intensity of the first band (the BS band), the C/N value deteriorates.

Therefore, in a machine, e.g., a hard disk recording and reproducing apparatus, that incorporates the tuner 10, a screen is displayed for selecting the broadcasting wave to be viewed during channel setup, as shown in FIG. 6. If the user sees the screen during channel setup and has no interest in the CS broadcasting wave, the user may uncheck a check mark. In the screen, it is also possible to uncheck the check mark for the BS broadcasting.

The tilt correction is not performed at least when the check mark for the CS broadcasting is unchecked.

Such a process is equivalent to an adjusting part that detects whether it is set not to view the CS broadcasting band and does not perform the tilt correction when the CS broadcasting band is not viewed.

### Fourth Embodiment

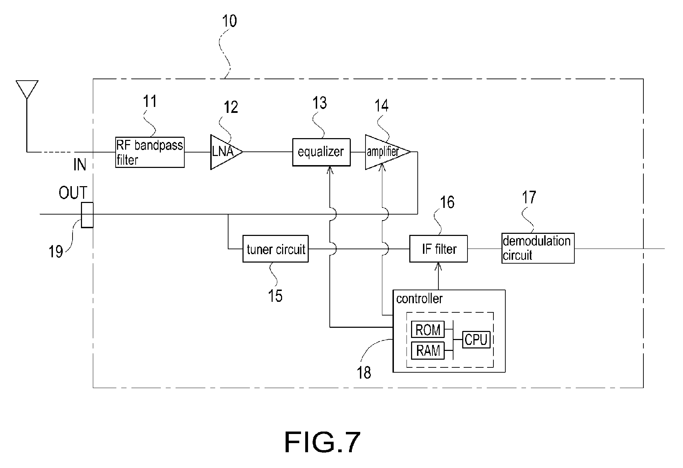

FIG. 7 is a block diagram of the receiving device according to another embodiment.

In the receiving device shown in FIG. 1, the receiving signal whose gain and frequency characteristic are improved by the equalizer 13 and the amplifier 14 is outputted to the tuner circuit 15. Only the receiving signal that is from the antenna before improvement is outputted to the antenna output terminal 19. If an external device includes a tilt correction circuit, it is preferable to input the signal before improvement, or it is suitable for a case where it is known that the CS broadcasting is not received by the external device.

That is, the configuration includes an antenna output terminal for the external device, and an output of the adjusting par is supplied to the tuner and not supplied to the antenna output terminal.

On the other hand, in the receiving device shown in FIG. 7, the improved receiving signal is also outputted to the antenna output terminal 19. By doing so, even if a device, which serves as the external device and requires an antenna signal, does not include the tilt correction circuit, reception in the CS band is still possible.

That is, the configuration includes the antenna output terminal for the external device, and the output of the adjusting part is supplied to the tuner and the antenna output terminal.

### Fifth Embodiment

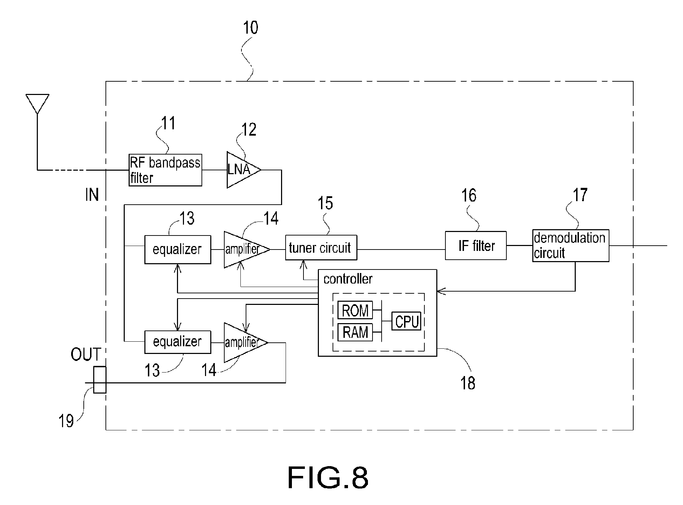

FIG. 8 is a block diagram of the receiving device according to another embodiment.

In the receiving device shown in FIG. 8, a pair of the equalizer 13 and the amplifier 14 is provided for the tuner circuit 15 and the antenna output terminal 19 individually. Accordingly, the improved receiving signal is outputted to both the tuner circuit 15 and the antenna output terminal 19, and is improved by the independent equalizer 13 and amplifier 14 respectively. If only one pair of the equalizer 13 and the amplifier 14 is provided, the capacity has to be increased.

However, if the tuner circuit 15 and the antenna output terminal 19 are provided with the equalizer 13 and the amplifier 14 independently, it is possible to use only one of them and therefore each having small capacity may still achieve the effects of the invention.

That is, the configuration includes the antenna output terminal for the external device, and the aforementioned adjusting parts are respectively provided for the tuner circuit and the antenna output terminal.

### Sixth Embodiment

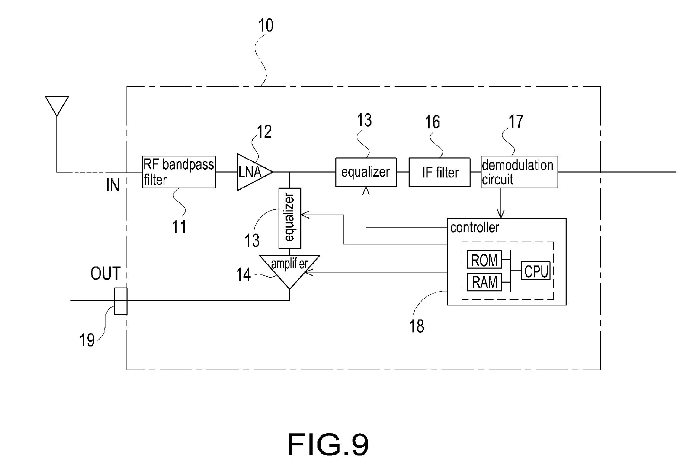

FIG. 9 is a block diagram of the receiving device according to another embodiment.

In the receiving device shown in FIG. 9, the equalizer 13 and the amplifier 14 are provided only for the antenna output terminal 19. Accordingly, the improved receiving signal is not outputted to the tuner circuit 15. Because the antenna signal passing through the receiving device is outputted to the external device, a certain degree of attenuation is inevitable. In order to avoid this problem, the improved receiving signal is outputted only to the antenna output terminal 19.

That is, the configuration includes the antenna output terminal for the external device, and the output of the adjusting part is not supplied to the tuner circuit but supplied to the antenna output terminal.

Needless to say, the invention is not limited to the embodiments described above. It should be understood by those skilled in the art that the following is disclosed as one embodiment of the invention.

Mutually substitutable members, configurations, etc. disclosed in the embodiment can be used with their combination altered appropriately.

Although not disclosed in the embodiment, members, configurations, etc. that belong to the known technology and can be substituted with the members, the configurations, etc. disclosed in the embodiment can be appropriately substituted or be used by altering their combination.

Although not disclosed in the embodiment, members, configurations, etc. that those skilled in the art can consider as substitutions of the members, the configurations, etc. disclosed in the embodiment are substituted with the above mentioned appropriately or are used by altering their combination.

### Reference Numerals

10: tuner
11: RF band-pass filter
12: low noise amplifier (LNA)
13: equalizer
14: amplifier
15: tuner circuit
16: IF filter (low-pass filter, LPF)
17: demodulation circuit
18: controller
19: antenna output terminal
20: decoder

## Claims

1. A receiving device (10), **characterized in that** the receiving device (10) comprises:
a tuner circuit (15) configured to be capable of receiving broadcasting signals
a frequency characteristic detector (18) configured to detect a tilt in a predetermined frequency band, wherein the tilt is presented by connecting waveform peaks that show a frequency characteristic of a receiving signal; and
an adjusting part (13, 14) configured to change the tilt by adjusting a signal level of the predetermined frequency band.

2. The receiving device (10) according to claim 1, **characterized in that** the receiving device (10) comprises a reception condition detector (17, 18), configured to detect a reception condition in a multiple channels of the predetermined frequency band, wherein the frequency characteristic detector (18) is configured to detect the tilt of the waveform of the frequency characteristic based on the reception condition.

3. The receiving device (10) according to claim 1 or 2, **characterized in that** the predetermined frequency band comprises a range which covers a first frequency band and a second frequency band having a higher frequency than the first frequency band.

4. The receiving device (10) according to claim 3, **characterized in that** the frequency characteristic detector (18) is configured to detect the tilt of the waveform of the frequency characteristic based on a reception condition in a channel of the first frequency band and a reception condition in a channel of the second frequency band, and the adjusting part (13, 14) makes an adjustment to reduce the tilt if the tilt exceeds a predetermined threshold value.

5. The receiving device (10) according to any one of claims 2 to 4, **characterized in that** the reception condition detector (17, 18) is configured to detect a C/N value of each channel.

6. The receiving device (10) according to claim 5, **characterized in that** the frequency characteristic detector (18) is configured to detect the tilt of the waveform of the frequency characteristic based on a difference between a maximum of the C/N values in the first frequency band and a minimum of the C/N values in the second frequency band, or based on a difference between a minimum of the C/N values in the first frequency band and a maximum of the C/N values in the second frequency band.

7. The receiving device (10) according to claim 5 or 6, **characterized in that** the adjusting part (13, 14) is configured to lower a level of the first frequency band and raise a level of the second frequency band if the C/N values of the first frequency band are large.

8. The receiving device (10) according to claim 5 or 6, **characterized in that** the adjusting part (13, 14) is configured to lower the level of the second frequency band and raise the level of the first frequency band if the C/N values of the second frequency band are large.

9. The receiving device (10) according to any one of claims 2 to 4, **characterized in that** the reception condition detector (17, 18) is configured to detect a BER value of each channel.

10. The receiving device (10) according to claim 9, **characterized in that** the frequency characteristic detector (30) is configured to detect the tilt of the waveform of the frequency characteristic based on a difference between a maximum of the BER values in the first frequency band and a minimum of the BER values in the second frequency band, or based on a difference between a minimum of the BER values in the first frequency band and a maximum of the BER values in the second frequency band.

11. The receiving device (10) according to claim 9 or 10, **characterized in that** the adjusting part (13, 14) is configured to lower the level of the first frequency band and raise the level of the second frequency band if the BER values of the first frequency band are small.

12. The receiving device (10) according to claim 9 or 10, **characterized in that** the adjusting part (13, 14) is configured to lower the level of the second frequency band and raise the level of the first frequency band if the BER values of the second frequency band are small.

13. The receiving device (10) according to any one of claims 2 to 12, **characterized in that** after the adjusting part (13, 14) adjusts the tilt, if the tilt of the waveform of the frequency characteristic detected by the frequency characteristic detector (18) based on the reception condition is larger than the tilt before the adjustment, the adjusting part (13, 14) undo the adjustment made to the tilt.

14. The receiving device (10) according to any one of claims 1 to 13, **characterized in that** the adjusting part (13, 14) comprises an equalizer (13) and an amplifier (14), wherein the equalizer (13) is configured to make an adjustment to reduce the tilt and the amplifier adjusts a gain of the entire frequency band.

15. The receiving device (10) according to any one of claims 1-14, **characterized in that** the frequency band comprises a terrestrial digital broadcasting band.
